# EUROPÄISCHE PATENTANMELDUNG

(11) **EP 4 351 285 A1**
(43) Veröffentlichungstag der Anmeldung: **10.04.2024**
(21) Anmeldenummer: 22199521.0
(22) Anmeldetag: 04.10.2022
(51) Int. Cl.: H05K 1/11, H05K 3/34, H05K 1/02

(54) **VERFAHREN ZUM HERSTELLEN EINES MIT EINER ANZAHL AN BAUTEILEN BESTÜCKTEN KRAFTFAHRZEUGSCHEINWERFERSCHALTUNGSTRÄGERS**

(71) Anmelder: ZKW Group GmbH, 3250 Wieselburg (AT)
(72) Erfinder: Haiden, Christoph, 2630 Ternitz (AT); Emmerich, Albrecht, 1150 Wien (AT); Kalkbrenner, Philip, 2700 Wiener Neustadt (AT)
(74) Vertreter: Patentanwaltskanzlei Matschnig & Forsthuber OG

(57) **Zusammenfassung**

Die Erfindung betrifft ein Verfahren zum Herstellen eines mit einer Anzahl an Bauteilen (2', 2") bestückten Kraftfahrzeugscheinwerferschaltungsträgers (1), wobei diese Anzahl an Bauteilen (2', 2") eine Anzahl an Pins (2a) aufweist, über die die Bauteile (2', 2") mit dem Kraftfahrzeugscheinwerferschaltungsträger (1) verbunden sind, indem diese in eine im Kraftfahrzeugscheinwerferschaltungsträger (1) dazu korrespondierend ausgebildete Anzahl an Öffnungen (1a) eingreifen und darin mittels Lötverbindungen (3) verlötet sind, wobei der Kraftfahrzeugscheinwerferschaltungsträger (1) zur Qualitätskontrolle der Lötverbindungen (3) durch Bereitstellen einer Anzahl an mit geschmolzenem Lötgut benetzbaren Indikatorflächen (4) vorbereitet ist, wobei das Verfahren die folgenden Schritte umfasst:
a) Bereitstellen eines Kraftfahrzeugscheinwerferschaltungsträgers (1),
b) Bestücken des Kraftfahrzeugscheinwerferschaltungsträgers (1) mit der Anzahl an Bauteilen (2', 2"),
c) Durchführen eines Lötvorganges zur Herstellung von Lötverbindungen (3) zur Verbindung der Anzahl an Bauteilen (2) mit dem Kraftfahrzeugscheinwerferschaltungsträger (1).

## Beschreibung

Die Erfindung betrifft ein Verfahren zum Herstellen eines mit einer Anzahl an Bauteilen (beliebig wählbar, z.B. eins, zwei, mehr als zwei, mehr als zehn, mehr als zwanzig, etc.) bestückten Kraftfahrzeugscheinwerferschaltungsträgers, wobei diese Anzahl an Bauteilen (z.B. Stecker, Kühler, elektronische Bauteile wie Chips, ICs, Kondensatoren, Spulen, Widerstände, etc.) eine Anzahl an Pins (z.B. ein, zwei oder mehr Pins pro Bauteil) aufweist, über die die Bauteile mit dem Kraftfahrzeugscheinwerferschaltungsträger verbunden sind, indem diese in eine im Kraftfahrzeugscheinwerferschaltungsträger dazu korrespondierend ausgebildete Anzahl an Öffnungen eingreifen und darin mittels Lötverbindungen verlötet sind, wobei der Kraftfahrzeugscheinwerferschaltungsträger zur Qualitätskontrolle der Lötverbindungen durch Bereitstellen einer Anzahl (z.B. zumindest eine Indikatorfläche pro Kraftfahrzeugscheinwerferschaltungsträger; es kann eine beliebige Anzahl an Indikatorflächen vorgesehen sein, die bis zur Anzahl der Öffnungen betragen kann) an mit geschmolzenem Lötgut benetzbaren Indikatorflächen (auch wetting indicator genannt) vorbereitet ist, wobei das Verfahren die folgenden Schritte umfasst:
a) Bereitstellen eines Kraftfahrzeugscheinwerferschaltungsträgers, wobei der Kraftfahrzeugscheinwerferschaltungsträgers eine erste Außenseite und eine der ersten Außenseite gegenüberliegende zweite Außenseite aufweist, wobei der Kraftfahrzeugscheinwerferschaltungsträger eine Anzahl an den Kraftfahrzeugscheinwerferschaltungsträger durchsetzenden Öffnungen zur Aufnahme der Pins der zu verbindenden Anzahl an Bauteilen aufweist, wobei sich diese Öffnungen von der ersten Außenseite über einen der ersten Außenseite zugewandten Öffnungseingang hin zu einem Öffnungsausgang erstrecken, der in die zweite Außenseite mündet, wobei zumindest eine Teilmenge der Öffnungsausgänge mit jeweils zumindest einer mit geschmolzenem Lötgut benetzbaren Indikatorfläche verbunden ist und damit eine Anzahl an Indikatorflächen vorgesehen ist,
b) Bestücken des Kraftfahrzeugscheinwerferschaltungsträgers mit der Anzahl an Bauteilen, wobei die Pins der Bauteile in die korrespondierende Anzahl an Öffnungen gemäß Schritt a) eingesetzt werden,
c) Durchführen eines Lötvorganges zur Herstellung von Lötverbindungen zur Verbindung (mechanisch, elektrisch und/oder thermisch) der Anzahl an Bauteilen mit dem Kraftfahrzeugscheinwerferschaltungsträger.

Schaltungsträger, die bei Kraftfahrzeugen eingesetzt werden, sind erhöhten mechanischen Belastungen (in Folge von Erschütterungen bei der Fahrt) als auch gröberen Umwelteinflüssen (z.B. starke Feuchtigkeits- und Temperaturschwankungen) ausgesetzt. Diesen erhöhten Belastungen müssen die beteiligten Komponenten und die Lötverbindungen derselben standhalten. Es gelten im Automobilbereich daher besonders strenge Anforderungen, denen die eingesetzten Vorrichtungen standhalten müssen.

Zur Überprüfung der Qualität von Lötverbindungen ist der Einsatz von mit Lötgut benetzbaren Indikatorflächen bekannt geworden. Eine Schwierigkeit bei der Qualitätskontrolle von Lötverbindungen besteht dabei darin, dass die Indikatorflächen bisher nur indikativ für die Benetzung der Lötstelle in unmittelbarer Umgebung der Indikatorfläche waren, da das Lötgut der Lötstelle umfassend die Indikatorfläche in der Regel direkt zugeführt wurde. Über die Qualität der Lötverbindung abseits der Indikatorfläche ließen sich bisher nur ungenaue Aussagen treffen.

Eine Aufgabe der Erfindung besteht daher darin, diesen Nachteil zu beheben. Diese Aufgabe wird mit einem Verfahren der Eingangs genannten Art gelöst, bei welchem erfindungsgemäß Schritt c) in einem Aspekt c1) ausgebildet ist, wonach die Anzahl an Bauteilen dergestalt angeordnet wird und für den Lötvorgang vorgesehenes Lötgut über die erste Außenseite des Kraftfahrzeugscheinwerferschaltungsträger dergestalt zugeführt wird, dass bei jeder Öffnung, die von einem Pin eines korrespondierenden Bauteils durchsetzt ist, im Zuge des Lötvorganges aufgeschmolzenes Lötgut über den Öffnungseingang durch die Öffnung hindurch bis hin zu dem Öffnungsausgang gesogen wird, und dabei die Indikatorflächen der Anzahl an Indikatorflächen über den jeweils zugeordneten Öffnungsausgang mit dem durch die entsprechende Öffnung getretenem Lötgut in Kontakt treten, insbesondere diese benetzen, sofern die Menge an eingebrachten Lötgut hierzu genügt.

Da die Indikatorfläche also an einer Seite angeordnet ist, die der Seite, über die das Lötgut zugeführt wird, gegenüberliegt, lässt eine Überprüfung der Indikatorfläche einen Rückschluss auf die Qualität der gesamten Lötverbindung zu. Ist nämlich die Indikatorfläche ausreichend benetzt, impliziert dieser Umstand, dass eine ausreichende Menge an Lötgut der Öffnung zugeführt und durch diese hindurch bis zu Indikatorfläche geleitet wurde. Die Ausbreitung von aufgeschmolzenem Lötgut innerhalb der Öffnung sowie hin zur Indikatorfläche kann durch Kapillarkräfte, Ausnutzung der Schwerkraft und vorteilhafte Oberflächenbenetzungseigenschaften (wie z.B. der Ausbildung der zu benetzenden Flächen aus Kupfer) der betreffenden Flächen gefördert werden. Im Falle der Anwendung von Reflow-Löten ("pin in paste") wird Lötgut in Form von Lötpaste bereits vor dem Bestücken gemäß Schritt b) aufgebracht. Bei Verwendung von Wellenlöten hingegen Lötgut erst im Zuge des Lötvorganges zugeführt, also nach Schritt b).

Insbesondere kann vorgesehen sein, dass die durch Lötgut benetzbaren Indikatorflächen als Kupferflächen ausgebildet sind, die vorzugsweise von einer die Indikatorflächen umgebenden Lötstopplackschicht begrenzt sind. Die Kupferflächen sind meistens mit einem Finish, also einer Oberflächenbeschichtung/-behandlung, versehen. Dabei kann es sich z.B. um HAL, eine chemische Beschichtung mit Zinn/Silber/Gold, eine galvanische Beschichtung usw. handeln. Auch solcherart oberflächenbehandelte Kupferflächen werden in der vorliegenden Erfindung als "Kupferflächen" verstanden und bezeichnet. Entweder ist die benetzbare Fläche durch den Lötstopplack begrenzt oder die benetzbare Fläche ist einfach durch die Form der benetzbaren Fläche begrenzt (freigeätzte Kupferstrukturen entsprechen einem typischen Leiterplattenherstellungsprozess). Es gibt auch Lötstopplackfreistellungen, die die benetzbare Fläche nicht überlappen und damit auch nicht begrenzen.

Weiters kann vorgesehen sein, dass jede Indikatorfläche einen Ring aufweist, der an den Öffnungsausgang angrenzt und/oder durch einen Spalt, der zwischen dem Öffnungsausgang und einem eingesetzten Pin entsteht, ausgebildet wird. Ein Kriterium bei der Überprüfung kann eine vollständige Benetzung des Ringes sein.

Insbesondere kann vorgesehen sein, dass eine Anzahl der Indikatorflächen geradlinige Fortsätze aufweist, die sich von dem Ring in radialer Richtung nach außen erstrecken. Nach außen bedeutet dabei weg von der Ringmitte. Dadurch wird die Überprüfung der Indikatorflächen vereinfacht, da die abstehenden Fortsätze einfach erfasst werden können.

Weiters kann vorgesehen sein, dass je Indikatorfläche zumindest vier Fortsätze vorgesehen sind, wobei diese Fortsätze gleichmäßig entlang des Umfangs des Ringes verteilt sind, sodass durch gedachte Verbindungslinien voneinander gegenüberliegenden Fortsätzen zumindest ein Kreuz ausgebildet wird, das den Mittelpunkt des Ringes schneidet. Der Einsatz der Fortsätze kann die Genauigkeit der Qualitätsprüfung der Lötstelle erhöhen und/oder erleichtern. Insbesondere kann vorgesehen sein, dass jeder Fortsatz mit einer jeweiligen Länge von dem Ring absteht, wobei jede Länge zwischen 10µm und 6000µm beträgt. Weiters kann vorgesehen sein, dass jeder Fortsatz mit einer Länge von dem Ring absteht, wobei die Fortsätze, die dem gleichen Ring zugeordnet sind, voneinander unterschiedliche Längen aufweisen, wobei die Längen jeweils zumindest 20% voneinander abweichen. Auf diese Weise kann auch die eingebrachte Istmenge an Lötgut bestimmt werden, die z.B. mit einer Sollmenge verglichen und adaptiert werden kann. Insbesondere kann vorgesehen sein, dass jeder Fortsatz eine Breite aufweist, die zwischen 0,1mm und 0,7mm beträgt, wobei vorzugsweise jeder Ring einen Durchmesser zwischen 0,8mm und 2,5mm und eine Dicke von 200µm aufweist. Die Breite wird dbaei mit einem rechten Winkel zur Länge gemessen. Unter dem Ausdruck "Dicke" wird die Differenz aus Außen- und Innenradius verstanden. Die angegebenen Größenbereiche haben sich als besonders vorteilhaft erwiesen.

Weiters kann vorgesehen sein, dass der Ring und/oder die gradlinigen Fortsätze gegenüber einer zur zweiten Außenseite parallel orientierten Ebene in Richtung des Öffnungsausgangs geneigt sind, wobei vorzugsweise der Neigungswinkel gemessen in Bezug auf die parallel orientierte Ebene zwischen 10° und 60° beträgt. Auf diese Weise wird die Benetzung der Indikatorfläche durch das Lötgut erleichtert, da dieses im Vergleich zu einem ausschließlich rechtwinkeligen Übergang unter einem flacheren Winkel von Innenfläche des Öffnungsausgangs hin zur Indikatorfläche gelangen kann.

Insbesondere kann vorgesehen sein, dass zumindest eine Teilmenge jener Öffnungsausgänge, die mit einer Indikatorfläche verbunden sind, vorzugsweis ausgehend von einer zylindrischen Bohrung, in Richtung zu der zweiten Außenseite durch Übergang in eine konische oder gerundete Mantelfläche verbreitert sind, sodass jeweils ein Öffnungswinkel gemessen zwischen der zweiten Außenseite und dem angrenzenden Bereich des Öffnungsausgangs weniger als 90°, vorzugsweise maximal 60°, beträgt. Auf diese Weise wird die Benetzung der Indikatorfläche durch das Lötgut erleichtert, da dieses im Vergleich zu einer ausschließlich vertikalen Bohrung unter einem flacheren Winkel zur Indikatorfläche gelangen kann.

Weiters kann vorgesehen sein, dass nach dem Durchführen des Lötvorganges gemäß Schritt c1) der folgende Schritt ausgeführt wird:
d) Inspektion der Lötverbindungen durch Erstellen von Röntgenaufnahmen unter Erfassung der Anzahl an Indikatorflächen, wobei der Zustand der Benetzung der Indikatorflächen zur Bewertung der Qualität der Lötverbindungen herangezogen wird.

Insbesondere kann vorgesehen sein, dass nach dem Durchführen des Lötvorganges gemäß Schritt c) der folgende Schritt ausgeführt wird:
d) Inspektion der Lötverbindungen durch Erstellen von optischen Aufnahmen unter Erfassung der Anzahl an Indikatorflächen, wobei der Zustand der Benetzung der Indikatorflächen zur Bewertung der Qualität der Lötverbindungen herangezogen wird. Dabei können z.B. Kameraaufnahmen vorgenommen werden. Auch ist eine Kombination mit Röntgenaufnahmen grundsätzlich denkbar. Ergänzend oder alternativ dazu kann auch eine manuelle visuelle Inspektion durch eine Prüfperson erfolgen.

Weiters kann vorgesehen sein, dass die Inspektion gemäß Schritt d) automatisiert erfolgt und zur Auswertung der Aufnahmen ein computergestützter Algorithmus ausgeführt wird, wobei der Benetzungszustand der Indikatorfläche vermessen und mit zumindest einem vorgebbaren Schwellwert verglichen wird.

Insbesondere kann vorgesehen sein, dass der Zustand der Benetzung jedes Fortsatzes erfasst wird, wobei die Länge des längsten Fortsatzes so bemessen ist, dass dieser bei der Wahl einer optimalen Menge an Lötgut jedenfalls nicht vollständig benetzt wird, und die Länge des kürzesten Fortsatzes so bemessen ist, dass dieser bei Wahl einer optimalen Menge an Lötgut jedenfalls vollständig benetzt ist, wobei im Falle der unvollständigen Benetzung des kürzesten Fortsatzes ein Signal ausgeben wird, um die zugeführte Menge an Lötgut zu erhöhen, und im Falle einer vollständigen Benetzung des längsten Fortsatzes das Signal manipuliert und ausgegeben wird, um die zugeführte Menge an Lötgut zu reduzieren. Sind die Indikatorflächen nicht ausreichend benetzt, so wird die Zufuhr an Lötgut erhöht, z.B. durch Aufbringen von einer größeren Pastenmenge im Falle von Pastendruck oder durch Erhöhen der Zufuhr über das Wellenlöten. So kann die im Verfahren eingesetzte Lötmenge iterativ adaptiert werden. Wird das Verfahren daher laufend ausgeführt, kann die Lötgutmenge in einem optimalen Bereich geführt werden - leichte Abweichungen bei der Produktion eines bestückten Kraftfahrzeugscheinwerferschaltungsträgers können bereits bei der Produktion des nächsten bestückten Kraftfahrzeugscheinwerferschaltungsträgers ausgeglichen werden. Der Grad der Benetzung der verbleibenden Fortsätze kann zur Feineinstellung der optimalen Lötmenge herangezogen werden. Vorzugsweise kann ein Größenzuwachs zwischen 20% und 100% zu dem nächstgrößeren Fortsatz vorgesehen sein. Die Zufuhr von Lötgut kann auch durch Manipulation der Löttemperatur und/oder der Zeitdauer des Lötvorganges beeinflusst werden. So kann z.B. das Zerfließen des Lots auch über Temperatur bzw. das TemperaturProfil im Reflow-Ofen manipuliert werden. Auch die Lotzusammensetzung beeinflusst die Fließfähigkeit des Lots in die Indikatorflächen.

Weiters kann vorgesehen sein, dass zwischen Schritt a) und b) zumindest auf eine Anzahl der den Kraftfahrzeugscheinwerferschaltungsträgers durchsetzenden Öffnungseingänge Lötpaste aufgebracht wird, und wobei nach dem Bestücken gemäß Schritt b) die Lötpaste von einem jeweiligen Pin durchsetzt ist, wobei der Lötvorgang gemäß Schritt c) durch Reflow-Löten erfolgt, und zwar dergestalt, dass die Lötpaste aufgeschmolzen wird, sodass daraus erhaltenes Lötgut durch den jeweiligen Öffnungseingang hin zu dem jeweiligen Öffnungsausgang gesogen wird. Ein großer Vorteil von dieser "Pin in Paste"-Technologie liegt in dem Umstand, dass die Bauteile via Reflow-Lötprozess verlötet werden können. Verglichen mit einem Alternativprozess wie z.B. Wellenlöten ergibt sich zudem der Vorteil, dass das Bauteil durch Haftung an der Lötpaste nach der Bestückung bis hin zum Lötprozess besser in Position gehalten wird.

Alternativ dazu kann vorgesehen sein, dass in Schritt b) die zweite Außenseite des Kraftfahrzeugscheinwerferschaltungsträgers mit den Bauteilen bestückt wird, und der Lötvorgang gemäß Schritt c) durch Wellenlöten erfolgt, und zwar dergestalt, dass dabei die erste Außenseite des Kraftfahrzeugscheinwerferschaltungsträgers während des Lötvorganges einer Lötwelle zur Aufnahme von Lötgut zugewandt ist, sodass das Lötgut durch den jeweiligen Öffnungseingang hin zu dem jeweiligen Öffnungsausgang gesogen wird. Die Indikatorflächen müssen nicht in elektrischem Wirkkontakt mit weiteren elektrischen (abgesehen von der Öffnungsfläche) Flächen sein, allerdings können diese durchaus zur weiteren Verbindung mit anderen elektrisch leitfähigen Flächen genutzt werden. Die abstehenden Indikatorflächen sind vorteilhafterweise so angeordnet, so dass sie senkrecht zur Leiterplattenebene gesehen nicht mit Bauteilen überlappen, also die Normalprojektion der Bauteile auf die Leiterplattenebene nicht mit den Indikatorflächen überlappt. Es kann dabei auch ein meist Selektivlötverfahren eingesetzt werden, bei dem die Lötwelle auf lokal bestimmte Stellen der Leiterplatte begrenzt ist, die mit Lot benetzt werden sollen.

Weiters betrifft die Erfindung einen Kraftfahrzeugscheinwerferschaltungsträgers aufweisend eine Anzahl an Bauteilen, hergestellt nach einem erfindungsgemäßen Verfahren. Sofern dies nicht explizit ausgeschlossen wird, können alle im Verfahren genannten Strukturellen Merkmale des Schaltungsträgers sowie der Bauteile können auch Teil des Schaltungsträgers sein.

Die Indikatorflächen können auch als benetzbare Auslaufbereiche bezeichnet werden. Weiters können noch folgende Aspekte vorgesehen sein: Die Indikatorfläche kann nach außen spitz zulaufen oder abgerundete Ecken aufweisen.

Die Erfindung ist im Folgenden anhand beispielhafter und nicht einschränkender Ausführungsformen näher erläutert, die in den Figuren veranschaulicht sind. Darin zeigt
Figur 1a eine Draufsicht auf eine Oberseite eines für das erfindungsgemäße Verfahren vorbereiteten Kraftfahrzeugscheinwerferschaltungsträgers,
Figur 1b eine Draufsicht auf die Unterseite des Kraftfahrzeugscheinwerferschaltungsträgers nach Fig. 1,
Figuren 2a bis 2c Schnittdarstellungen unterschiedlicher Zustände eines Ausschnitts des Schaltungsträgers nach Fig. 1 und 2 für die Anwendung in einem Reflow-Lötverfahren,
Figur 3 eine Detailansicht einer Lötverbindung,
Figur 4a eine Darstellung eines alternativen vorbereiteten Kraftfahrzeugscheinwerferschaltungsträgers für die Anwendung in einem Reflow-Lötverfahren,
Figur 4b eine Darstellung einer bei dem Schaltungsträger gemäß Fig. 4a hergestellten Lötverbindung,
Figur 5a eine Draufsicht auf eine Oberseite eines weiteren für das erfindungsgemäße Verfahren vorbereiteten Kraftfahrzeugscheinwerferschaltungsträgers für die Anwendung eines Wellenlötverfahrens,
Figur 5b eine Draufsicht auf eine Unterseite des Schaltungsträgers gemäß Fig. 5a,
Figur 6a eine Schnittdarstellung des Schaltungsträgers gemäß Fig. 5a und 5b in einem ersten Zustand,
Figur 6b eine Schnittdarstellung des Schaltungsträgers gemäß Fig. 5a und 5b in einem zweiten Zustand,
Figur 6c eine Schnittdarstellung des Schaltungsträgers gemäß Fig. 5a und 5b in einem dritten Zustand,
Figur 6d eine detailliertere Schnittdarstellung des Schaltungsträgers gemäß Fig. 5a und 5b in einem vierten Zustand,
Figur 7a eine Darstellung eines alternativen vorbereiteten Kraftfahrzeugscheinwerferschaltungsträgers für die Anwendung in einem Wellenlötverfahren,
Figur 7b eine detailliertere Schnittdarstellung des Schaltungsträgers gemäß Fig. 7a in einem zweiten Zustand,
Figuren 8a bis 8g beispielhafte Indikatorflächen und Benetzungszustände derselben,
Figuren 9a bis 9c beispielhafte Abschrägungen innerhalb der Indikatorflächen,
Figuren 10a und 10b zwei Beispiele bezüglich der Herstellung von Abschrägungen.

In den folgenden Figuren bezeichnen - sofern nicht anders angegeben - gleiche Bezugszeichen gleiche Merkmale.

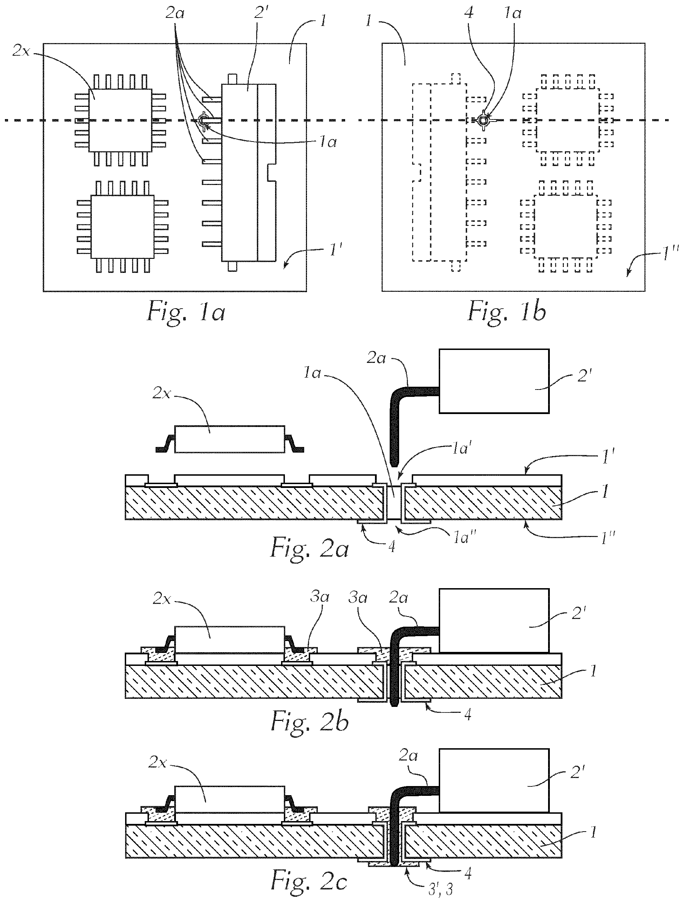

Fig. 1a zeigt eine Draufsicht auf eine Oberseite 1', im vorliegenden Beispiel auch erste Außenseite 1' genannt, eines für das erfindungsgemäße Verfahren vorbereiteten Kraftfahrzeugscheinwerferschaltungsträgers 1. Der Träger 1 ist mit einer Anzahl an Bauteilen 2' und 2x bestückt. Das Bauteil 2x ist als oberflächenmontiertes Bauteil ausgeführt. Das Bauteil 2' hingegen weist Pins 2a auf, über das Bauteil 2' mit dem Kraftfahrzeugscheinwerferschaltungsträger 1 verbunden ist, indem es in eine im Kraftfahrzeugscheinwerferschaltungsträger 1 dazu korrespondierend ausgebildete Anzahl an Öffnungen 1a eingreift und darin mittels Lötverbindungen 3 (siehe Fig. 2c) verlötet ist.

Figur 1b zeigt eine Draufsicht auf die Unterseite, im vorliegenden Beispiel auch zweite Außenseite 1" genannt, des Kraftfahrzeugscheinwerferschaltungsträgers 1 nach Fig. 1.

Figuren 2a bis 2c zeigen Schnittdarstellungen unterschiedlicher Zustände eines Ausschnitts des Schaltungsträgers 1 nach Fig. 1 und 2 für die Anwendung in einem Reflow-Lötverfahren. Der Kraftfahrzeugscheinwerferschaltungsträger 1 ist zur Qualitätskontrolle der Lötverbindungen 3 durch Bereitstellen einer Anzahl an mit geschmolzenem Lötgut benetzbaren Indikatorflächen 4 vorbereitet ist, wobei das erfindungsgemäße Verfahren die folgenden Schritte umfasst:
a) Bereitstellen eines Kraftfahrzeugscheinwerferschaltungsträgers 1, wobei der Kraftfahrzeugscheinwerferschaltungsträgers 1 eine erste Außenseite 1' und eine der ersten Außenseite gegenüberliegende zweite Außenseite 1" aufweist, wobei der Kraftfahrzeugscheinwerferschaltungsträger 1 eine Anzahl an den Kraftfahrzeugscheinwerferschaltungsträger 1 durchsetzenden Öffnungen 1a zur Aufnahme der Pins 2a der zu verbindenden Anzahl an Bauteilen 2', 2" aufweist, wobei sich diese Öffnungen 1a von der ersten Außenseite 1' über einen der ersten Außenseite 1' zugewandten Öffnungseingang 1a' hin zu einem Öffnungsausgang 1a" erstrecken, der in die zweite Außenseite 1" mündet, wobei zumindest eine Teilmenge der Öffnungsausgänge 1a" mit jeweils zumindest einer mit geschmolzenem Lötgut benetzbaren Indikatorfläche 4 verbunden ist und damit eine Anzahl an Indikatorflächen 4 vorgesehen ist,
b) Bestücken des Kraftfahrzeugscheinwerferschaltungsträgers 1 mit der Anzahl an Bauteilen 2', 2", wobei die Pins 2a der Bauteile 2 in die korrespondierende Anzahl an Öffnungen 1a gemäß Schritt a) eingesetzt werden,
c) Durchführen eines Lötvorganges zur Herstellung von Lötverbindungen 3 zur Verbindung der Anzahl an Bauteilen 2', 2" mit dem Kraftfahrzeugscheinwerferschaltungsträger 1 (siehe Fig. 2c).

Das Lötgut 3' liegt vorliegend in Form von Lötpaste 3a vor, die dann aufgeschmolzen wird, um eine Lötverbindung herzustellen. Dabei wird in dem vorliegenden Ausführungsbeispiel das sogenannte Reflow-Lötverfahren angewendet. Man erkennt in Fig. 2c deutlich, dass das Bauteil 2' dergestalt angeordnet wird und für den Lötvorgang vorgesehenes Lötgut 3' über die erste Außenseite 1' des Kraftfahrzeugscheinwerferschaltungsträger 1 dergestalt zugeführt wird, dass bei jeder Öffnung 1a, die von einem Pin 2a des Bauteils 2' durchsetzt ist, im Zuge des Lötvorganges aufgeschmolzenes Lötgut 3' über den Öffnungseingang 1a' durch die Öffnung 1a hindurch bis hin zu dem Öffnungsausgang 1a" gesogen wird, und dabei die Indikatorflächen 4 der Anzahl an Indikatorflächen 4 über den jeweils zugeordneten Öffnungsausgang 1a" mit dem durch die entsprechende Öffnung 1a getretenem Lötgut 3' in Kontakt treten und vorliegend die Indikatorfläche 4 benetzt. Figur 2a zeigt deinen Zustand, in dem der Träger 1 noch nicht mit Lötpaste 3a versehen ist. Fig. 2b zeigt einen Zustand, in dem die Lötpaste 3a bereits aufgebracht wurde und die Bauteile 2x, 2' in die passende Position gebracht wurden, allerdings noch kein Aufschmelzen der Paste 3a vorgenommen wurde. Fig. 2c zeigt den Endzustand, in dem die Paste 3a aufgeschmolzen und in eine Lötverbindung 3 umfassend ausgehärtes Lötgut 3' umgewandelt wurde. Anders ausgedrückt wird bei diesem Verfahren zwischen Schritt a) und b) zumindest auf eine Anzahl der den Kraftfahrzeugscheinwerferschaltungsträgers 1 durchsetzenden Öffnungseingänge 1a' Lötpaste 3a aufgebracht, und wobei nach dem Bestücken gemäß Schritt b) die Lötpaste 3a von einem jeweiligen Pin 2a durchsetzt ist, wobei der Lötvorgang gemäß Schritt c) durch Reflow-Löten erfolgt, und zwar dergestalt, dass die Lötpaste 3a aufgeschmolzen wird, sodass daraus erhaltenes Lötgut 3' durch den jeweiligen Öffnungseingang 1a' hin zu dem jeweiligen Öffnungsausgang 1a" gesogen wird.

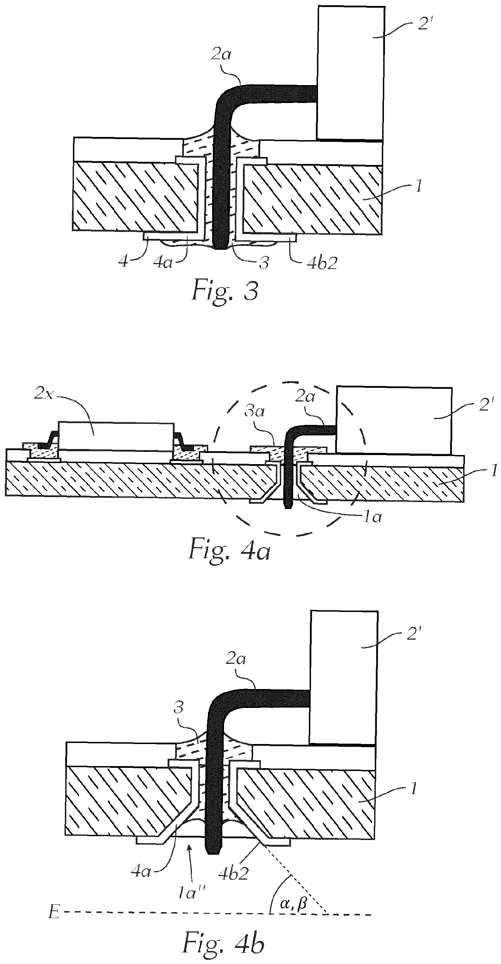

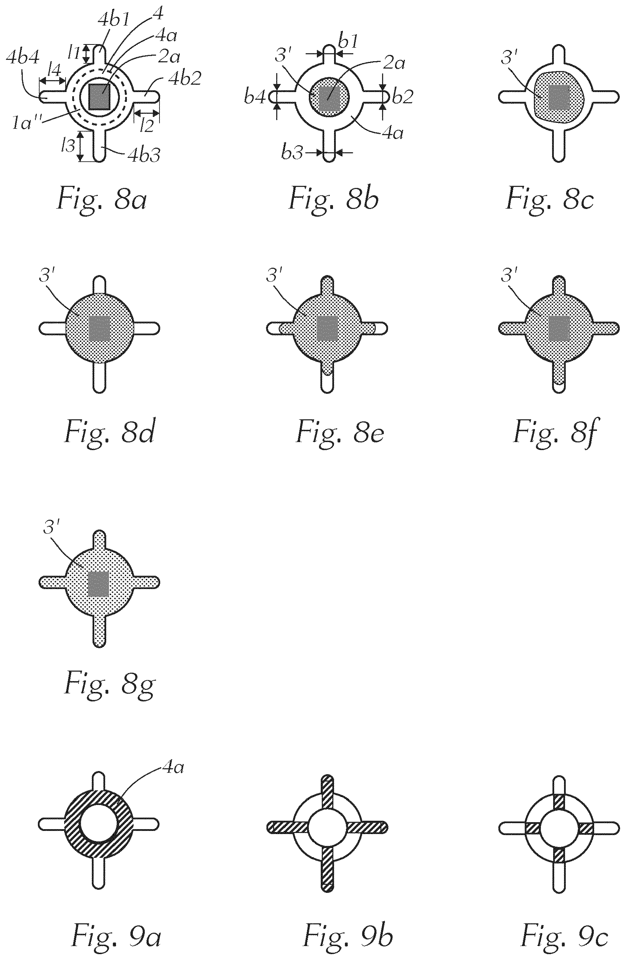

Figur 3 zeigt eine Detailansicht einer auf diese Weise hergestellten Lötverbindung 3. Die Indikatorfläche 4 ist dabei durch das Lötgut sehr gut benetzt, wobei die Indikatorfläche 4 sowohl einen Ring 4a sowie damit verbundene Fortsätze aufweist, wobei beispielhaft der Fortsatz 4b2 mit einem Bezugszeichen versehen ist. Eine detaillierte Darstellung einer beispielhaften Indikatorfläche kann z.B. auch Fig. 8a entnommen werden. Die Lötverbindung 3 gemäß Fig. 3 ist durchgängig, frei von Einschlüssen und daher von guter Qualität. Das Lötgut füllt die Öffnung 1a vollständig aus hat sich durch diese bis hin zur Indikatorfläche 4a ausreichend ausgebreitet. Der Benetzungszustand der Indikatorfläche 4a gemäß Fig. 3 ist ein Hinweis auf eine sehr gut ausgebildete Lötverbindung.

Figur 4a zeigt eine Darstellung eines alternativen vorbereiteten Kraftfahrzeugscheinwerferschaltungsträgers 1 für die Anwendung in einem Reflow-Lötverfahren. Figur 4b zeigt eine Darstellung einer bei dem Schaltungsträger 1 gemäß Fig. 4a hergestellten Lötverbindung 3, die diesmal eine geringere Menge an Lötgut aufweist, als jene in Fig. 3. Anders als in der Ausführungsform gemäß Fig. 3 sind in der Ausführungsform gemäß Fig. 4a und 4b der Ring 4a und die gradlinigen Fortsätze (mit beispielhafter Beschriftung des Fortsatzes 4b2) gegenüber einer zur zweiten Außenseite 1" parallel orientierten Ebene E in Richtung des Öffnungsausgangs 1a" geneigt sind, wobei vorzugsweise der Neigungswinkel α gemessen in Bezug auf die parallel orientierte Ebene zwischen 10° und 60° beträgt. Zudem ist in Fig. 4a und 4b erkennbar, dass der Öffnungsausgang la", die mit einer Indikatorfläche 4 verbunden sind, vorzugsweis ausgehend von einer zylindrischen Bohrung, in Richtung zu der zweiten Außenseite 1" durch Übergang in eine konische oder gerundete Mantelfläche verbreitert sind, sodass jeweils ein Öffnungswinkel β gemessen zwischen der zweiten Außenseite 1" und dem angrenzenden Bereich des Öffnungsausgangs 1a" weniger als 90°, vorzugsweise maximal 60°, beträgt. Vorliegend stimmen die Winkel α und β überein, da der konisch geneigte Mantel des Öffnungsausgangs 1a" direkt in den Ring 4a sowie die Fortsätze übergeht.

Die durch Lötgut 3' benetzbaren Indikatorflächen 4 können als Kupferflächen ausgebildet sein, die vorzugsweise von einer die Indikatorflächen 4 umgebenden Lötstopplackschicht begrenzt sind.

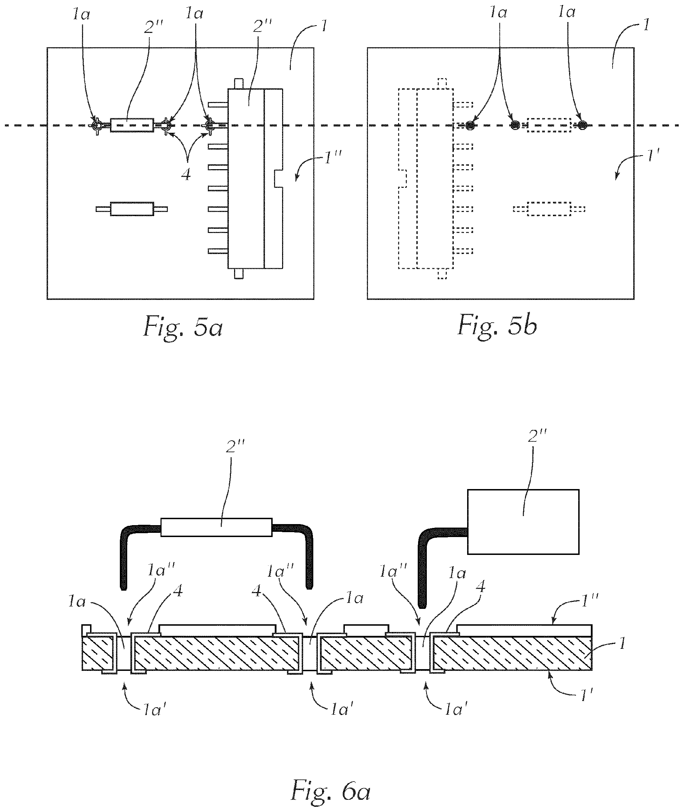

Figur 5a zeigt eine Draufsicht auf eine Oberseite eines weiteren für das erfindungsgemäße Verfahren vorbereiteten Kraftfahrzeugscheinwerferschaltungsträgers 1 für die Anwendung eines Wellenlötverfahrens. Figur 5b zeigt eine Draufsicht auf eine Unterseite des Schaltungsträgers 1 gemäß Fig. 5a. In Schritt b) die zweite Außenseite 2' des Kraftfahrzeugscheinwerferschaltungsträgers 1 mit den Bauteilen 2 bestückt. Anders als bei dem bereits beschriebenen Reflow-Lötverfahren wird vorliegend der Lötvorgang gemäß Schritt c) durch Wellenlöten durchgeführt, und zwar dergestalt, dass dabei die erste Außenseite 1' des Kraftfahrzeugscheinwerferschaltungsträgers 1 während des Lötvorganges einer Lötwelle zur Aufnahme von Lötgut 3' zugewandt ist, sodass das Lötgut 3' durch den jeweiligen Öffnungseingang 1a' hin zu dem jeweiligen Öffnungsausgang 1a" gesogen wird. Die hierfür eingesetzte Lötwelle kann auch lokal auf einen ausgewählten Bereich des Schaltungsträgers 1 begrenzt sein. Es ist daher möglich, Bauteile an beiden Seiten des Trägers 1 anzuordnen (wie auch beim Reflow-Lötverfahren).

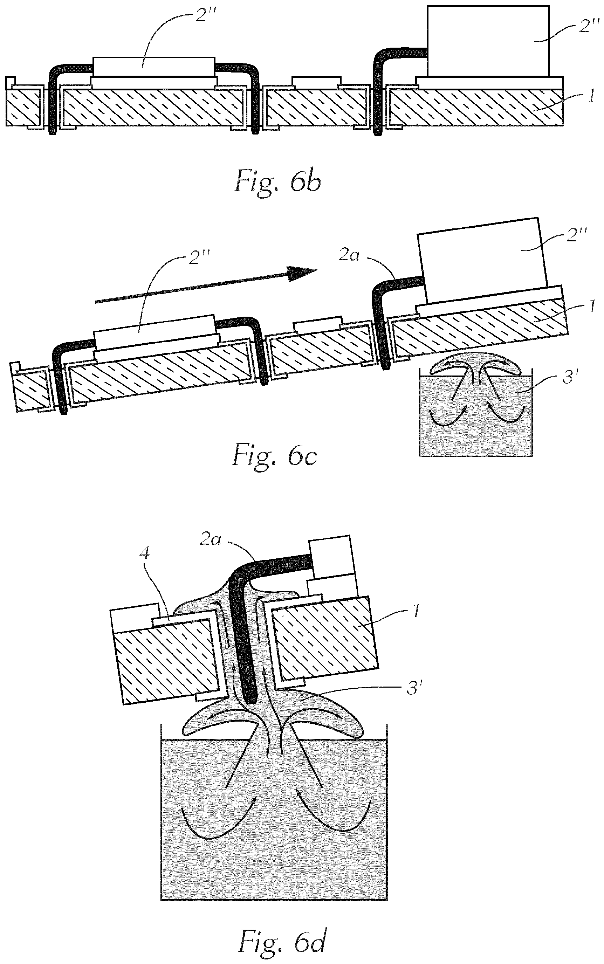

Figuren 6a bis 6d zeigen eine Schnittdarstellung des Schaltungsträgers 1 gemäß Fig. 5a und 5b in vier aufeinander folgenden Zuständen. Fig. 6a zeigt den Bestückungsvorgang. Fig. 6b zeigt einen Zustand, in dem Bauteile 2" auf den Schaltungsträger 1 aufgesetzt wurden. Die Pins 2a dieser Bauteile können dabei durch die Öffnung 1a vollständig hindurch ragen und dadurch die Aufnahme von Lötgut des Wellenlötbades begünstigen. Fig. 6c zeigt den Träger 1, wie dieser über das Lötgut 3' in Form eines Wellenlötbades geführt wird, Fig. 6d zeigt eine Momentaufnahme, in der Lötgut 3' einen Pin 2a berührt und entlang des Pins 2a durch die Öffnung 1a gesogen wird. Die Indikatorfläche 4 befindet sich dabei auf einer Oberseite des Trägers 1. Grundsätzlich ist vorgesehen, dass die Indikatorflächen 4 jener Seite angeordnet sind, die der Zufuhrseite, über die das Lötgut 3' zugeführt wird, gegenüber liegt. Auf diese Weise wird sichergestellt, dass die Benetzung einer Indikatorfläche 4 ein vorangegangenes Durchdringen der Öffnung 1a mit Lötgut 3' impliziert.

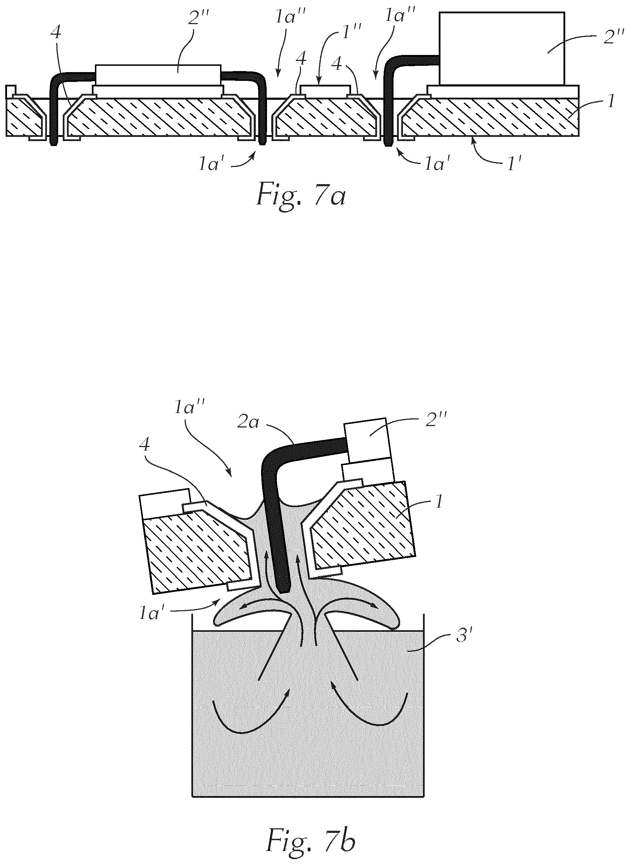

Figur 7a zeigt eine Darstellung eines alternativen vorbereiteten Kraftfahrzeugscheinwerferschaltungsträgers 1 für die Anwendung in einem Wellenlötverfahren. Auch in dieser Ausführungsform wird ein Wellenlötverfahren angewendet, allerdings ist anders als in Fig. 6a bis 6d die Öffnung 1a hin zur Indikatorfläche 4 konisch verbreitert, wie dies auch schon mit Blick auf Fig. 4a und 4b beschrieben wurde.

Figur 7b zeigt eine detailliertere Schnittdarstellung des Schaltungsträgers 1 gemäß Fig. 7a in einem zweiten Zustand, in dem das Lötgut 3' durch die Öffnung 1a gesogen wurde, und zwar vom Öffnungseingang 1a' hin zum Öffnungsausgang 1a". Durch die konische Verbreiterung kann das Lötgut 3' einfacher auf die Indikatorfläche 4 übergehen, sodass eine höhere Genauigkeit bei der Überprüfung erzielt werden kann.

Figuren 8a bis 8g beispielhafte Indikatorflächen 4 und Benetzungszustände derselben sowie jeweils einen darin aufgenommen Pin 2a. Es kann dabei vorgesehen sein, dass jede Indikatorfläche 4 einen in Fig. 8a strichliert angedeutet Ring 4a aufweist, der an den Öffnungsausgang 1a" angrenzt und/oder durch einen Spalt, der zwischen dem Öffnungsausgang 1a" und einem eingesetzten Pin 2a entsteht, ausgebildet wird. Die Indikatorflächen 4 weisen geradlinige Fortsätze 4b1, 4b2, 4b3, 4b4 auf, die sich von dem Ring 4a in radialer Richtung nach außen erstrecken. Vorliegend weist die Indikatorfläche 4 genau vier Fortsätze 4b1, 4b2, 4b3, 4b4 auf, wobei diese Fortsätze 4b1, 4b2, 4b3, 4b4 gleichmäßig entlang des Umfangs des Ringes 4a verteilt sind, sodass durch gedachte Verbindungslinien voneinander gegenüberliegenden Fortsätzen 4b1, 4b2, 4b3, 4b4 zumindest ein Kreuz ausgebildet wird, das den Mittelpunkt des Ringes 4a schneidet. Jeder Fortsatz 4b1, 4b2, 4b3, 4b4 steht mit einer jeweiligen Länge 11, 12, 13, 14 von dem Ring 4a ab, wobei jede Länge zwischen 10µm und 6000µm beträgt. Die Fortsätze 4b1, 4b2, 4b3, 4b4 weisen voneinander unterschiedliche Längen 11,12,13,14 auf, wobei die Längen jeweils zumindest 20% voneinander abweichen. Auf diese Weise kann der Benetzungszustand der Indikatorfläche besonders genau erfasst werden. Vorzugweise weist jeder Fortsatz 4b1, 4b2, 4b3, 4b4 eine Breite b1, b2, b3, b4 auf, die zwischen 0,1mm und 0,7mm beträgt, wobei vorzugsweise jeder Ring 4a einen Durchmesser zwischen 0,8mm und 2,5mm und eine Dicke von 200µm aufweist.

In Fig. 8b ist ein Pin mit rechteckigem Querschnitt gezeigt, der in geringem Ausmaß mit Lötgut 3' benetzt ist. Der Ring 4a, dessen Innengrenze genau an dem Lötgut 3' angrenzt, wird allerdings noch nicht benetzt. In Fig. 8c ist bereits eine größere Menge an Lötgut 3' vorhanden, der Ring 4a wird aber noch nicht vollständig benetzt. Erst in Fig. 8d ist der Ring vollständig benetzt, die Fortsätze hingegen nicht. Fig. 8e und Fig. 8f können z.B. einen Idealzustand darstellen, in dem eine ideale Menge an Lötgut 3' die Öffnung 1a durchsetzt hat und die Indikatorfläche 4 mitsamt den Fortsätzen benetzt. Im Fall von Fig. 8g sind sämtliche Fortsätze vollständig benetzt, woraus schlussgefolgert werden kann, dass die Menge an Lötgut 3' reduziert werden kann, um Überschüsse und die Bildung von Lötklumpen zu vermeiden.

Figuren 9a bis 9c zeigen beispielhafte Abschrägungen innerhalb der Indikatorflächen 4, wobei die Abschrägungen in Form von schraffierten Flächen verdeutlicht sind. Die Abschrägung, z.B. in Form einer konischen Geometrie, kann ausschließlich den Ring 4a (Fig. 9a), ausschließlich die Fortsätze (Fig. 9b) oder auch bloß jene Bereiche des Ringes betreffen, der in die Fortsätze übergeht (Fig. 9c).

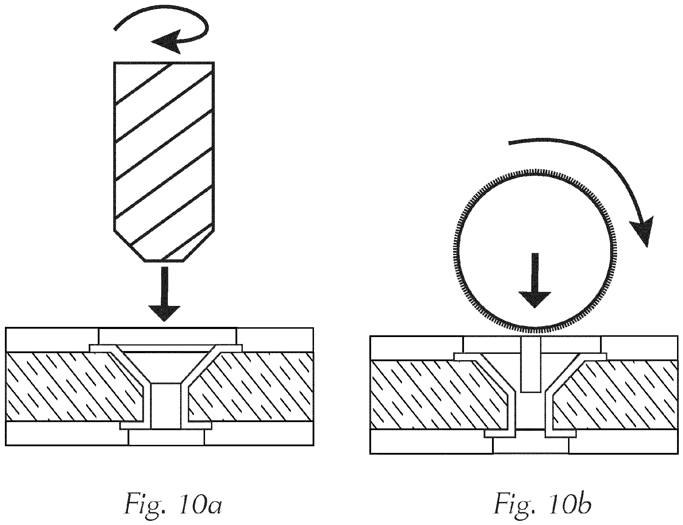

Fig. 10a und 10b zeigen zwei Beispiele wie die Abschrägungen bzw. Gräben hergestellt werden können, und zwar z.B. durch Bohren (siehe Fig. 10a) oder auch z.B. durch eine Kreissäge oder einen Fräser (siehe Fig. 10b).

Die Erfindung ermöglicht die Inspektion der Lötverbindungen 3. Hierzu kann vorgesehen sein, dass nach dem Durchführen des Lötvorganges gemäß Schritt c1) der folgende Schritt ausgeführt wird: d) Inspektion der Lötverbindungen 3 durch Erstellen von Röntgenaufnahmen unter Erfassung der Anzahl an Indikatorflächen 4, wobei der Zustand der Benetzung der Indikatorflächen 4 zur Bewertung der Qualität der Lötverbindungen 3 herangezogen wird. Ergänzend oder alternativ dazu kann vorgesehen sein, dass nach dem Durchführen des Lötvorganges gemäß Schritt c) der folgende Schritt ausgeführt wird: d) Inspektion der Lötverbindungen 3 durch Erstellen von optischen Aufnahmen unter Erfassung der Anzahl an Indikatorflächen 4, wobei der Zustand der Benetzung der Indikatorflächen 4 zur Bewertung der Qualität der Lötverbindungen 3 herangezogen wird.

Die Inspektion gemäß Schritt d) kann automatisiert erfolgen und zur Auswertung der Aufnahmen kann ein computergestützter Algorithmus ausgeführt werden, wobei der Benetzungszustand der Indikatorfläche vermessen und mit zumindest einem Schwellwert verglichen werden kann. Vorzugsweise wird dabei der Zustand der Benetzung jedes Fortsatzes 4b1, 4b2, 4b3, 4b4 erfasst, wobei die Länge des längsten Fortsatzes so bemessen ist, dass dieser bei der Wahl einer optimalen Menge an Lötgut 3' jedenfalls nicht vollständig benetzt wird, und die Länge des kürzesten Fortsatzes so bemessen ist, dass dieser bei Wahl einer optimalen Menge an Lötgut 3' jedenfalls vollständig benetzt ist, wobei im Falle der unvollständigen Benetzung des kürzesten Fortsatzes ein Signal ausgeben wird, um die zugeführte Menge an Lötgut 3' zu erhöhen, und im Falle einer vollständigen Benetzung des längsten Fortsatzes das Signal manipuliert und ausgegeben wird, um die zugeführte Menge an Lötgut 3' zu reduzieren. Sind die Indikatorflächen nicht ausreichend benetzt, so wird die Zufuhr an Lötgut erhöht, z.B. durch Aufbringen von einer größeren Pastenmenge im Falle von Pastendruck oder durch Erhöhen der Zufuhr über das Wellenlöten, mittels des Signals kann dann z.B. die Herstellung in einer nachfolgenden Iteration adaptiert werden. Wird das Verfahren daher laufend ausgeführt, kann die Lötgutmenge in einem optimalen Bereich geführt werden - leichte Abweichungen bei der Produktion eines bestückten Kraftfahrzeugscheinwerferschaltungsträgers können bereits bei der Produktion des nächsten bestückten Kraftfahrzeugscheinwerferschaltungsträgers ausgeglichen werden. Der Grad der Benetzung der verbleibenden Fortsätze kann zur Feineinstellung der optimalen Lötmenge herangezogen werden.

Die Erfindung betrifft zudem einen Kraftfahrzeugscheinwerferschaltungsträgers 1 aufweisend eine Anzahl an Bauteilen 2, hergestellt nach einem erfindungsgemäßen Verfahren, sowie einen Kraftfahrzeugscheinwerfer umfassend einen erfindungsgemäßen Kraftfahrzeugscheinwerferschaltungsträger 1. Alle in den Verfahren genannten strukturellen Merkmale des Schaltungsträgers 1 sowie der genannten Komponenten können auch Teil des Schaltungsträgers 1 bzw. einer darauf gerichteten Vorrichtung sein.

Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

## Patentansprüche

1. Verfahren zum Herstellen eines mit einer Anzahl an Bauteilen (2', 2") bestückten Kraftfahrzeugscheinwerferschaltungsträgers (1), wobei diese Anzahl an Bauteilen (2', 2") eine Anzahl an Pins (2a) aufweist, über die die Bauteile (2', 2") mit dem Kraftfahrzeugscheinwerferschaltungsträger (1) verbunden sind, indem diese in eine im Kraftfahrzeugscheinwerferschaltungsträger (1) dazu korrespondierend ausgebildete Anzahl an Öffnungen (1a) eingreifen und darin mittels Lötverbindungen (3) verlötet sind, wobei der Kraftfahrzeugscheinwerferschaltungsträger (1) zur Qualitätskontrolle der Lötverbindungen (3) durch Bereitstellen einer Anzahl an mit geschmolzenem Lötgut benetzbaren Indikatorflächen (4) vorbereitet ist, wobei das Verfahren die folgenden Schritte umfasst:
a) Bereitstellen eines Kraftfahrzeugscheinwerferschaltungsträgers (1), wobei der Kraftfahrzeugscheinwerferschaltungsträgers (1) eine erste Außenseite (1') und eine der ersten Außenseite gegenüberliegende zweite Außenseite (1") aufweist, wobei der Kraftfahrzeugscheinwerferschaltungsträger (1) eine Anzahl an den Kraftfahrzeugscheinwerferschaltungsträger (1) durchsetzenden Öffnungen (1a) zur Aufnahme der Pins (2a) der zu verbindenden Anzahl an Bauteilen (2', 2") aufweist, wobei sich diese Öffnungen (1a) von der ersten Außenseite (1') über einen der ersten Außenseite (1') zugewandten Öffnungseingang (1a') hin zu einem Öffnungsausgang (1a") erstrecken, der in die zweite Außenseite (1") mündet, wobei zumindest eine Teilmenge der Öffnungsausgänge (1a") mit jeweils zumindest einer mit geschmolzenem Lötgut benetzbaren Indikatorfläche (4) verbunden ist und damit eine Anzahl an Indikatorflächen (4) vorgesehen ist,
b) Bestücken des Kraftfahrzeugscheinwerferschaltungsträgers (1) mit der Anzahl an Bauteilen (2', 2"), wobei die Pins (2a) der Bauteile (2) in die korrespondierende Anzahl an Öffnungen (1a) gemäß Schritt a) eingesetzt werden,
c) Durchführen eines Lötvorganges zur Herstellung von Lötverbindungen (3) zur Verbindung der Anzahl an Bauteilen (2', 2") mit dem Kraftfahrzeugscheinwerferschaltungsträger (1),
**dadurch gekennzeichnet, dass**
c1) hierzu die Anzahl an Bauteilen (2', 2") dergestalt angeordnet wird und für den Lötvorgang vorgesehenes Lötgut (3') über die erste Außenseite (1') des Kraftfahrzeugscheinwerferschaltungsträger (1) dergestalt zugeführt wird, dass bei jeder Öffnung (1a), die von einem Pin (2a) eines korrespondierenden Bauteils (2) durchsetzt ist, im Zuge des Lötvorganges aufgeschmolzenes Lötgut (3') über den Öffnungseingang (1a') durch die Öffnung (1a) hindurch bis hin zu dem Öffnungsausgang (1a") gesogen wird, und dabei die Indikatorflächen (4) der Anzahl an Indikatorflächen (4) über den jeweils zugeordneten Öffnungsausgang (1a") mit dem durch die entsprechende Öffnung (1a) getretenem Lötgut (3') in Kontakt treten.

2. Verfahren nach einem der vorhergehenden Ansprüche, wobei die durch Lötgut (3') benetzbaren Indikatorflächen (4) als Kupferflächen ausgebildet sind, die vorzugsweise von einer die Indikatorflächen (4) umgebenden Lötstopplackschicht begrenzt sind.

3. Verfahren nach einem der vorhergehenden Ansprüche, wobei jede Indikatorfläche (4) einen Ring (4a) aufweist, der an den Öffnungsausgang (1a") angrenzt und/oder durch einen Spalt, der zwischen dem Öffnungsausgang (1a") und einem eingesetzten Pin (2a) entsteht, ausgebildet wird.

4. Verfahren nach Anspruch 3, wobei eine Anzahl der Indikatorflächen (4) geradlinige Fortsätze (4b1, 4b2, 4b3, 4b4) aufweist, die sich von dem Ring (4a) in radialer Richtung nach außen erstrecken.

5. Verfahren nach Anspruch 4, wobei je Indikatorfläche (4) zumindest vier Fortsätze (4b1, 4b2, 4b3, 4b4) vorgesehen sind, wobei diese Fortsätze (4b1, 4b2, 4b3, 4b4) gleichmäßig entlang des Umfangs des Ringes (4a) verteilt sind, sodass durch gedachte Verbindungslinien voneinander gegenüberliegenden Fortsätzen (4b1, 4b2, 4b3, 4b4) zumindest ein Kreuz ausgebildet wird, das den Mittelpunkt des Ringes (4a) schneidet.

6. Verfahren nach Anspruch 4 oder 5, wobei jeder Fortsatz (4b1, 4b2, 4b3, 4b4) mit einer jeweiligen Länge (11, 12, 13, 14) von dem Ring (4a) absteht, wobei jede Länge zwischen 10µm und 6000µm beträgt.

7. Verfahren nach einem der Ansprüche 4 bis 6, wobei jeder Fortsatz (4b1, 4b2, 4b3, 4b4) mit einer Länge (11, 12, 13, 14) von dem Ring (4a) absteht, wobei die Fortsätze (4b1, 4b2, 4b3, 4b4), die dem gleichen Ring (4a) zugeordnet sind, voneinander unterschiedliche Längen (11, 12, 13, 14) aufweisen, wobei die Längen jeweils zumindest 20% voneinander abweichen.

8. Verfahren nach einem der Ansprüche 4 bis 7, wobei jeder Fortsatz (4b1, 4b2, 4b3, 4b4) eine Breite (b1, b2, b3, b4) aufweist, die zwischen 0,1mm und 0,7mm beträgt, wobei vorzugsweise jeder Ring (4a) einen Durchmesser zwischen 0,8mm und 2,5mm und eine Dicke von 200µm aufweist.

9. Verfahren nach einem der Ansprüche 4 bis 8, wobei der Ring (4a) und/oder die gradlinigen Fortsätze (4b1, 4b2,4b3,4b4) gegenüber einer zur zweiten Außenseite (1") parallel orientierten Ebene (E) in Richtung des Öffnungsausgangs (1a") geneigt sind, wobei vorzugsweise der Neigungswinkel (a) gemessen in Bezug auf die parallel orientierte Ebene (E) zwischen 10° und 60° beträgt.

10. Verfahren nach einem der vorhergehenden Ansprüche, wobei zumindest eine Teilmenge jener Öffnungsausgänge (1a"), die mit einer Indikatorfläche (4) verbunden sind, vorzugsweis ausgehend von einer zylindrischen Bohrung, in Richtung zu der zweiten Außenseite (1") durch Übergang in eine konische oder gerundete Mantelfläche verbreitert sind, sodass jeweils ein Öffnungswinkel (β) gemessen zwischen der zweiten Außenseite (1") und dem angrenzenden Bereich des Öffnungsausgangs (1a") weniger als 90°, vorzugsweise maximal 60°, beträgt.

11. Verfahren nach einem der vorhergehenden Ansprüche, wobei nach dem Durchführen des Lötvorganges gemäß Schritt c1) der folgende Schritt ausgeführt wird:
d) Inspektion der Lötverbindungen (3) durch Erstellen von Röntgenaufnahmen () unter Erfassung der Anzahl an Indikatorflächen (4), wobei der Zustand der Benetzung der Indikatorflächen (4) zur Bewertung der Qualität der Lötverbindungen (3) herangezogen wird.

12. Verfahren nach einem der vorhergehenden Ansprüche, wobei nach dem Durchführen des Lötvorganges gemäß Schritt c) der folgende Schritt ausgeführt wird:
d) Inspektion der Lötverbindungen (3) durch Erstellen von optischen Aufnahmen () unter Erfassung der Anzahl an Indikatorflächen (4), wobei der Zustand der Benetzung der Indikatorflächen (4) zur Bewertung der Qualität der Lötverbindungen (3) herangezogen wird.

13. Verfahren nach Anspruch 11 oder 12, wobei die Inspektion gemäß Schritt d) automatisiert erfolgt und zur Auswertung der Aufnahmen () ein computergestützter Algorithmus ausgeführt wird, wobei der Benetzungszustand der Indikatorfläche vermessen und mit zumindest einem Schwellwert verglichen wird.

14. Verfahren nach Anspruch 4 und 13, wobei der Zustand der Benetzung jedes Fortsatzes (4b1, 4b2, 4b3, 4b4) erfasst wird, wobei die Länge des längsten Fortsatzes () so bemessen ist, dass dieser bei der Wahl einer optimalen Menge an Lötgut (3') jedenfalls nicht vollständig benetzt wird, und die Länge des kürzesten Fortsatzes () so bemessen ist, dass dieser bei Wahl einer optimalen Menge an Lötgut (3') jedenfalls vollständig benetzt ist, wobei im Falle der unvollständigen Benetzung des kürzesten Fortsatzes () ein Signal () ausgeben wird, um die zugeführte Menge an Lötgut (3') zu erhöhen, und im Falle einer vollständigen Benetzung des längsten Fortsatzes () das Signal () manipuliert und ausgegeben wird, um die zugeführte Menge an Lötgut (3') zu reduzieren.

15. Verfahren nach einem der vorhergehenden Ansprüche, wobei zwischen Schritt a) und b) zumindest auf eine Anzahl der den Kraftfahrzeugscheinwerferschaltungsträgers (1) durchsetzenden Öffnungseingänge (1a') Lötpaste (3a) aufgebracht wird, und wobei nach dem Bestücken gemäß Schritt b) die Lötpaste (3a) von einem jeweiligen Pin (2a) durchsetzt ist, wobei der Lötvorgang gemäß Schritt c) durch Reflow-Löten erfolgt, und zwar dergestalt, dass die Lötpaste (3a) aufgeschmolzen wird, sodass daraus erhaltenes Lötgut (3') durch den jeweiligen Öffnungseingang (1a') hin zu dem jeweiligen Öffnungsausgang (1a") gesogen wird.

16. Verfahren nach einem der Ansprüche 1 bis 14, wobei in Schritt b) die zweite Außenseite (2') des Kraftfahrzeugscheinwerferschaltungsträgers (1) mit den Bauteilen (2) bestückt wird, und der Lötvorgang gemäß Schritt c) durch Wellenlöten erfolgt, und zwar dergestalt, dass dabei die erste Außenseite (1') des Kraftfahrzeugscheinwerferschaltungsträgers (1) während des Lötvorganges einer Lötwelle zur Aufnahme von Lötgut (3') zugewandt ist, sodass das Lötgut (3') durch den jeweiligen Öffnungseingang (1a') hin zu dem jeweiligen Öffnungsausgang (1a") gesogen wird.

17. Kraftfahrzeugscheinwerferschaltungsträger (1) aufweisend eine Anzahl an Bauteilen (2), hergestellt nach einem Verfahren nach einem der vorhergehenden Ansprüche.
